# EUROPÄISCHE PATENTANMELDUNG

(11) **EP 1 329 952 A2**
(43) Veröffentlichungstag der Anmeldung: **23.07.2003**
(21) Anmeldenummer: 02026290.3
(22) Anmeldetag: 27.11.2002
(51) Int. Cl.: H01L 23/31, H01L 23/495

(54) **Verfahren zum Fixieren von Chipträgern**

(30) Priorität: 21.01.2002 DE 10202257
(71) Anmelder: W.C. Heraeus GmbH & Co. KG, 63450 Hanau (DE)
(72) Erfinder: Bauer, Alfred, 63755 Alzenau (DE); Hartmann, Horst, 63454 Hanau (DE); Kolodzei, Günter, 63791 Karlstein (DE)
(74) Vertreter: Kühn, Hans-Christian

(57) **Zusammenfassung**

Die Erfindung betrifft ein Verfahren zum Fixieren von Chipträgern, bei dem aus einer Metallfolie Leiterbahnen gestanzt werden, der Chip auf das resultierende Leiterbahnensystem aufgebracht wird und mit Bonddrähten kontaktiert und vergossen wird, wobei der Chipträger mit dem Chip so mit einer elektrisch isolierenden Schicht, vorzugsweise der Vergussmasse, überzogen wird, dass sie über diesen hinausreicht, so dass der Chipträger an der Metallfolie mit dieser isolierenden Schicht in Position gehalten wird, wenn sämtliche Metallkontakte zwischen Metallfolie und Chipträger durchtrennt werden.

## Beschreibung

Die Erfindung betrifft ein Verfahren zum kontaktlosen Fixieren von Chipträgern an Metallfolien gemäß dem Oberbegriff des Anspruchs 1.

Üblicherweise werden bei der Herstellung von kontaktlosen Chipkarten Leiterbahnen aus einer Metallfolie gestanzt. Durch die Ausbildung der Metallfolie als langgestreckter Filmstreifen mit einer periodischen Anordnung desselben Leiterbahnmusters können die integrierten Schaltungen mit Hilfe eines Automaten aufgebracht und kontaktiert werden. Gewöhnlich wird mit Bonddrähten kontaktiert und der Chip dann mit einer Gussmasse überzogen. Anschließend werden die integrierten Schaltungen mit dem umgebenden Leiterbahnmuster (die Chipträger) als ein Stück aus dem Filmstreifen ausgestanzt, in die entsprechenden Teile der Chip-Karten eingesetzt (vgl. DE 198 16 066).

Prozesstechnisch kann es erwünscht sein, die Elektronik des Chips zu testen, wenn er noch auf der Folie ist. Einige Tests gelingen, wenn der Chipträger an zwei aus der Metallfolie ausgebildeten Stegen (Massenstege) in Position gehalten wird. Für bestimmte Tests müssen aber sämtliche leitenden Verbindungen zur Metallfolie unterbrochen werden. Durch das Kappen der Verbindungen einschließlich der beiden Stege verliert der Chipträger dann seinen Halt.

Es stellt sich die Aufgabe, dem Chipträger Halt zu verleihen, damit elektrische Systemtests vorgenommen werden können, wenn sämtliche leitenden Verbindungen durchtrennt sind.

Die Aufgabe wird durch die Merkmale des Anspruchs 1 gelöst. Um den Chipträger nach dem Stanzen in Position zu halten, wird im Rahmen der vorliegenden Erfindung vorgeschlagen, auf dem Chip eine isolierende tragende Schicht aufzubringen, die über den Chip hinausreicht und in Verbindung mit dem umgebenden Folienband steht. Vorzugsweise wird dafür die oben beschriebene Gussmasse verwendet, die in flüssiger Form aufgetragen wird, besonders als fließfähiges, härtbares Material. Bevorzugt können ferner Verankerungsöffnungen oder Unterschneidungen an den dem Chipträger benachbarten Rändern der Metallfolie vorgesehen werden, in die Material fließen kann, um die Haltbarkeit zu erhöhen.

Alternativ kann auch die adhäsive Wirkung der isolierenden Schicht allein genutzt werden.

Die leitenden Verbindungen einschließlich der Massenstege werden anschließend - vorzugsweise durch Stanzen (Freistanzen) - durchtrennt, und der Chipträger hält sich durch die Verbindung mit der isolierenden Schicht in Position. Danach sind die gewünschten elektrischen Systemtests möglich.

Die Erfindung betrifft somit ein Verfahren zum Fixieren von Chipträgern, bei dem aus einer Metallfolie Leiterbahnen gestanzt werden, der Chip auf das resultierende Leiterbahnensystem aufgebracht wird und mit Bonddrähten kontaktiert und vergossen wird, wobei der Chipträger mit dem Chip so mit einer elektrisch isolierenden Schicht, vorzugsweise der Vergussmasse, überzogen wird, dass sie über diesen hinausreicht, so dass der Chipträger an der Metallfolie mit dieser isolierenden Schicht in Position gehalten wird, wenn sämtliche Metallkontakte zwischen Metallfolie und Chipträger durchtrennt werden.

Bevorzugt wird dabei die isolierende Schicht als flüssiges härtbares Material durch Gießen und Aushärten aufgebracht. In der Metallfolie können Verankerungsöffnungen vorgesehen sein, in die das flüssige Material eindringen kann.

Geeignete Metallfolien und Vergussmassen sind dem Fachmann bekannt.

Im folgenden wird eine mögliche Ausführungsform der Erfindung anhand von Zeichnungen näher erläutert. In den Zeichnungen zeigt:
Fig. 1 - einen Ausschnitt aus einer Metallfolie mit Chipträger,
Fig. 2 - einen Schnitt längs A-A aus Fig. 1 und
Fig. 3 - einen Ausschnitt aus einem Metallfolienband mit mehreren Chipträgern.

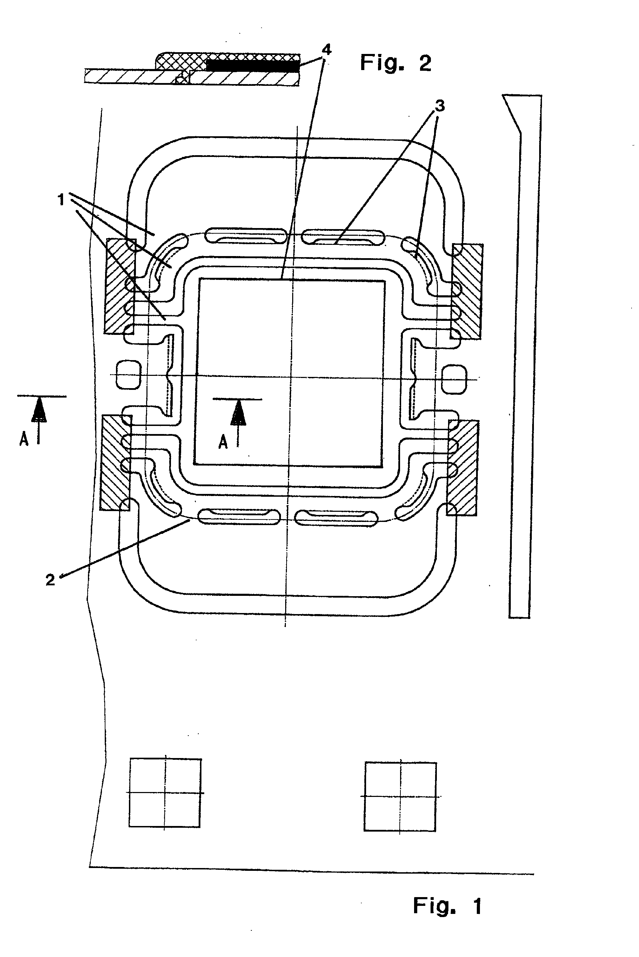

Fig. 1 zeigt eine Metallfolie mit bereits vorgestanzten Leiterbahnen (1), die an den schraffierten Stellen freigestanzt wird. Die gestrichelte Linie (2) zeigt den Umriss der aufgebrachten isolierenden Schicht. Die Umrisse des Chips sind durch das Quadrat (4) dargestellt. Die Bonddrähte sind nicht dargestellt. Die gestrichelten Linien (3) bedeuten die Lage von möglichen Unterschneidungen. Die Quadrate am unteren Rand stellen die Transportöffnungen des Bandes dar.

In Fig. 2 sieht man einen Schnitt entlang der Linie A - A, welche den Chip (4) [schwarz dargestellt, die Bonddrähte sind in der Zeichnung weggelassen] und den Überzug aus Vergussmasse (doppelt schraffiert) zeigt, der vor dem Freistanzen innerhalb der gestrichelten Linie (2) der Fig 1 aufgebracht wird. Die Unterschneidung ist als Stufe im linken einfach schraffierten Teil der Metallfolie zu sehen. Es ist möglich, die Unterschneidungen durch Prägen an der Metallfolie anzubringen. Alternativ dazu können Verankerungsöffnungen vorgesehen sein, die ebenfalls am Rand mit Unterschneidungen versehen werden können. Solche Öffnungen sind in Fig 1 und 2 nicht dargestellt.

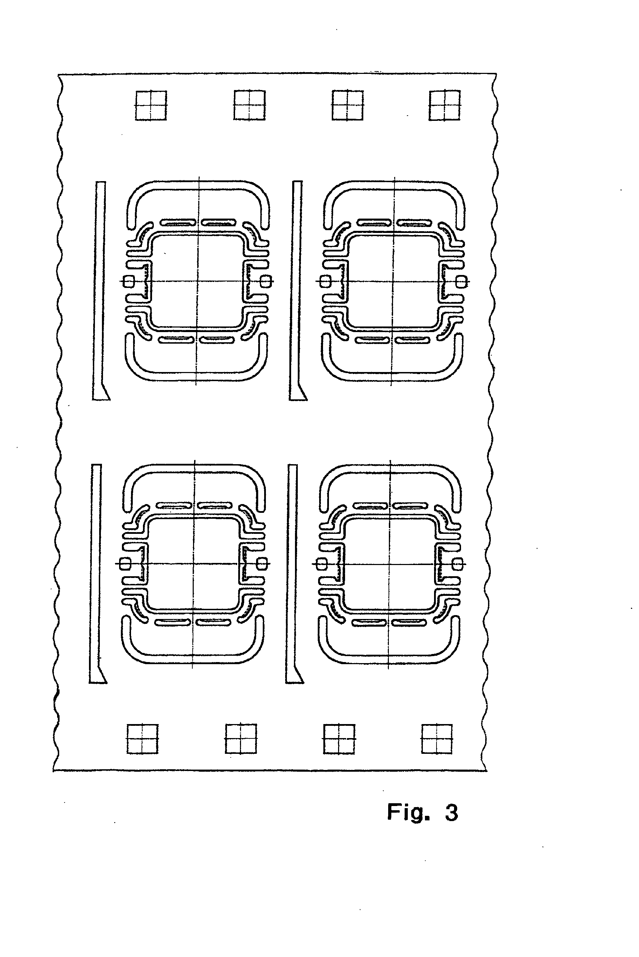

Die Fig. 3 zeigt einen Ausschnitt aus dem gesamten Filmstreifen bzw. Band mit sich wiederholender Anordnung des Schaltungsmusters der Fig. 1. Am Rand sieht man die quadratischen Transportöffnungen des Bandes.

## Patentansprüche

1. Verfahren zum Fixieren von Chipträgern, bei dem aus einer Metallfolie Leiterbahnen gestanzt werden, der Chip auf das resultierende Leiterbahnensystem aufgebracht wird und mit Bonddrähten kontaktiert und vergossen wird, **dadurch gekennzeichnet, dass** der Chipträger mit dem Chip so mit einer elektrisch isolierenden Schicht, vorzugsweise der Vergussmasse, überzogen wird, dass sie über diesen hinausreicht, so dass der Chipträger an der Metallfolie mit dieser isolierenden Schicht in Position gehalten wird, wenn sämtliche Metallkontakte zwischen Metallfolie und Chipträger durchtrennt werden.

2. Verfahren nach Anspruch 1, **dadurch gekennzeichnet, dass** die isolierende Schicht als flüssiges härtbares Material durch Gießen und Aushärten aufgebracht wird.

3. Verfahren nach Anspruch 1 oder 2, **dadurch gekennzeichnet, dass** Verankerungsöffnungen in der Metallfolie vorgesehen sind, in die das flüssige Material eindringen kann.

4. Verfahren nach Anspruch 1 oder 2, **dadurch gekennzeichnet, dass** eine oder mehrere Unterschneidung(en) an den dem Chipträger benachbarten Rändern der Metallfolie vorgesehen sind

5. Verfahren nach Anspruch 4, **dadurch gekennzeichnet, dass** die Unterschneidung(en) durch Prägen an der Metallfolie angebracht wird/werden.

6. Verfahren nach Anspruch 3, **dadurch gekennzeichnet, dass** die Verankerungsöffnungen mit Unterschneidungen versehen werden.
